# EUROPÄISCHE PATENTANMELDUNG

(11) **EP 1 217 500 A2**
(43) Veröffentlichungstag der Anmeldung: **26.06.2002**
(21) Anmeldenummer: 01128649.9
(22) Anmeldetag: 30.11.2001
(51) Int. Cl.: G06F 1/16

(54) **Anordnung zur Festlegung einer Rechnerkarte**

(30) Priorität: 21.12.2000 DE 10064115
(71) Anmelder: Fujitsu Siemens Computers GmbH, 81739 München (DE)
(72) Erfinder: Köhler, Friedrich, 86405 Meitingen (DE); Weishaupt, Werner, 86497 Horgau (DE)
(74) Vertreter: Epping Hermann & Fischer

(57) **Zusammenfassung**

Die Erfindung betrifft eine Anordnung zur Festlegung eines Slotwinkels (5) am Slotfeld (2) eines Computergehäuses (1). Erfindungsgemäß ist das Slotfeld (2) der Geometrie des Slotwinkels angepaßt, so daß durch das Schließen einer Abdeckung (9) des Computergehäuses (1) die Slotwinkel (5) automatisch durch Klemmung festgelegt sind.

## Beschreibung

Die Erfindung betrifft eine Anordnung zur Festlegung eines Slotwinkels mit im wesentlichen zwei aufeinander senkrecht stehenden Abschnitten am Slotfeld eines Computergehäuses.

Bisher erfolgte die Befestigung von Slotwinkeln beziehungsweise Slotkarten im PC-Gehäuse mittels Schrauben beziehungsweise mittels Zusatzteilen, welche eine Klemmung bewirken. Derartige Klemmzusatzteile sind zum Beispiel in der WO 97/34216, der DE 195 33 063 C1, der DE 295 20 867 U1 und der DE 196 06 797 C2 offenbart.

Die Zusatzteile zur Fixierung der Slotwinkel beziehungsweise Slotkarten haben gegenüber den Schrauben den Vorteil, daß diese aus Kunststoff gebildet sind und somit nicht die Gefahr von Kurzschlüssen wie bei herabfallenden Schrauben während der Montage besteht.

Jedoch sind nach wie vor zur Montage der Slotwinkel beziehungsweise Slotkarten getrennte Zusatzteile erforderlich, welche an das jeweilige PC-Gehäuse angepaßt sein müssen.

Der Erfindung liegt daher die Aufgabe zugrunde, eine Lösung aufzuzeigen, welche die separate Verwendung von Zusatzteilen vermeidet.

Diese Aufgabe wird erfindungsgemäß dadurch gelöst, daß das Slotfeld der Geometrie des Slotwinkels angepaßt ist, so daß beide Abschnitt des Slotwinkels von innen am Slotfeld anliegen und das Computergehäuse eine Abdeckung aufweist, die so ausgebildet ist, daß sie zumindest einen Abschnitt des Slotwinkels im geschlossenen Zustand durch Klemmen festlegt.

Diese Lösung hat den großen Vorteil, daß nach dem Öffnen der Abdeckung keine weiteren Montageschritte zum Tauschen der Slotwinkel beziehungsweise -karten notwendig sind. Auch nach dem Schließen des Deckels sind alle Slotwinkel beziehungsweise Slotkarten automatisch wieder festgelegt.

Gemäß einer bevorzugten Ausführungsform ist an der Abdeckung ein Befestigungsteil integriert beziehungsweise befestigt, über welches die Klemmung an den Slotwinkeln erfolgt.

Um eine ideale Klemmung zu erzielen, ist dieses Befestigungsteil vorzugsweise leicht elastisch ausgebildet. Durch die leichte Elastizität sind auch bei der Fertigung größere Maßtoleranzen zulässig.

Gemäß einer weiteren bevorzugten Ausführungsform umgreift das Befestigungsteil den Slotwinkel im fixierten Zustand im Winkel der aufeinander senkrecht stehenden Abschnitte.

Weitere vorteilhafte Ausgestaltungen der Erfindung sind in den Unteransprüchen offenbart.

Nachfolgend wird anhand eines in den Figuren dargestellten Ausführungsbeispieles die Erfindung näher erläutert.

### In den Figuren zeigen:

- Figur 1: den Bereich eines Computergehäuses mit Slotfeld und eingesetzten Slotkarten mit geschlossener Abdeckung im Schnitt und
- Figur 2: die Ansicht gemäß Figur 1 mit geöffneter Abdeckung.

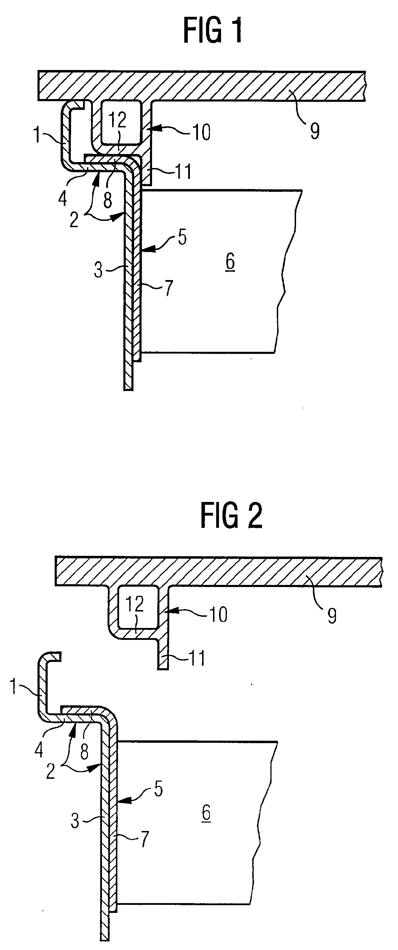

Figur 1 zeigt im Querschnitt den Teil eines Computergehäuses 1 im Bereich des Slotfeldes 2. Das Slotfeld 2 ist im dargestellten Ausführungsbeispiel in die Wandung des Computergehäuses 1 integriert.

Das Slotfeld 2 besteht aus zwei im wesentlichen aufeinander senkrecht stehenden Abschnitten 3 und 4. Auf das Slotfeld 2 ist von innen ein Slotwinkel 5 aufgelegt, welcher im dargestellten Ausführungsbeispiel mit einer Slotkarte 6 verbunden ist.

Der Slotwinkel 5 weist ebenso zwei senkrecht aufeinander stehende Abschnitte 7 und 8 auf, welche von innen auf den entsprechenden Abschnitten 3 und 4 des Slotfeldes 2 aufliegen. Das Slotfeld 2 ist in seiner Geometrie an diejenige der Slotwinkel 5 angepaßt, so daß diese auf die Innenseite des Slotfeldes 2 bündig und eng anliegend aufgelegt werden können.

Zur Festlegung der Slotwinkel 5 beziehungsweise der Slotkarten 6 mit den entsprechenden Slotwinkeln 5 weist das Computergehäuse eine Abdeckung 9 auf, welche im geschlossenen Zustand zumindest gegen den Abschnitt 8 des Slotwinkels 5 preßt und so diesen gegen den Abschnitt 4 des Slotfeldes 2 klemmt.

Im dargestellten Ausführungsbeispiel ist an der Abdeckung 9 ein Befestigungsteil 10 vorgesehen, welches ebenfalls zwei senkrecht aufeinander stehende Abschnitt 11 und 12 aufweist, welche so ausgebildet sind, daß sie im geschlossenen Zustand der Abdeckung 9 den Slotwinkel 5 im Winkel der Abschnitte 7 und 8 umgreifen, wobei der Abschnitt 12 gegen den Abschnitt 8 des Slotwinkels drückt und der Abschnitt 11 ein Herausziehen der Slotkarte verhindert und in gewissem Umfang ebenfalls den Abschnitt 7 des Slotwinkels 5 gegen den Abschnitt 3 des Slotfeldes 2 drückt.

Durch das Schließen der Abdeckung 9 sind somit alle im Computergehäuse befindlichen Slotwinkel 5 beziehungsweise Slotkarten 6 automatisch festgelegt. Eine getrennte Montage wie im Stand der Technik hat nicht mehr zu erfolgen.

Nach dem Öffnen der Abdeckung, wie in Figur 2 dargestellt, können alle Slotwinkel 5 beziehungsweise alle Slotkarten 6 entnommen werden, ohne daß vorher eine gesonderte Demontage erfolgen muß.

## Patentansprüche

1. Anordnung zur Festlegung eines Slotwinkels (5) mit im wesentlichen zwei aufeinander senkrecht stehenden Abschnitten (7, 8) am Slotfeld (2) eines Computergehäuses (1),
**dadurch gekennzeichnet, daß**
das Slotfeld (2) der Geometrie des Slotwinkels (5) angepaßt ist, so daß beide Abschnitte (7, 8) des Slotwinkels (5) von innen am Slotfeld (2) anliegen und das Computergehäuse (1) eine Abdeckung (9) aufweist, die so ausgebildet ist, daß sie zumindest einen Abschnitt (8) des Slotwinkels im geschlossenen Zustand durch Klemmung festlegt.

2. Anordnung nach Anspruch 1,
**dadurch gekennzeichnet, daß**
die Abdeckung (9) im geschlossenen Zustand beide Abschnitte (7, 8) des Slotwinkels (5) hintergreift.

3. Anordnung nach Anspruch 1 oder 2,
**dadurch gekennzeichnet, daß**
an der Abdeckung (9) ein Befestigungsteil (10) integriert ist.

4. Anordnung nach Anspruch 1 oder 2,
**dadurch gekennzeichnet, daß**
mit der Abdeckung (9) ein Befestigungsteil (10) verbunden ist.

5. Anordnung nach einem der Ansprüche 3 oder 4,
**dadurch gekennzeichnet, daß**
das Befestigungsteil (10) leicht elastisch ausgebildet ist.

6. Anordnung nach einem der Ansprüche 1 bis 5,
**dadurch gekennzeichnet, daß**
die Abdeckung (9) den Slotwinkel (5) im fixierten Zustand im Winkel der beiden aufeinander stehenden Abschnitte (7, 8) umgreift.

7. Anordnung nach einem der Ansprüche 1 bis 6,
**dadurch gekennzeichnet, daß**
der Slotwinkel (5) mit einer Slotkarte (6) verbunden ist.

8. Anordnung nach einem der Ansprüche 1 bis 7,
**dadurch gekennzeichnet, daß**
das Slotfeld (2) im Computergehäuse (1) integriert ist.
